# EUROPEAN PATENT APPLICATION

(11) **EP 2 863 364 A1**
(43) Date of publication of application: **22.04.2015**
(21) Application number: 13275335.1
(22) Date of filing: 23.12.2013
(51) Int. Cl.: G06T 17/00

(54) **Cloud 3D model construction system and construction method thereof**

(30) Priority: 16.10.2013 TW 102137272
(71) Applicant: Tsai, Shiann-Tsong, Hsinchu City (TW)
(72) Inventor: Tsai, Shiann-Tsong, Hsinchu City (TW)
(74) Representative: Potter Clarkson LLP

(57) **Abstract**

A cloud 3D model construction system and a related method thereof are provided. 3D object data of a physical object are transmitted in real time to a cloud 3D model platform. The cloud 3D model platform constructs a 3D model in construction based on the 3D object data. The 3D model in construction is updated to be constructed continuously, in order for a 3D model corresponding to the physical object to be created. A plane image of the 3D model in construction is sent to a user apparatus in real time, allowing the user apparatus to view the plane image of the 3D model in construction. The cloud 3D model construction system and method enable real-time viewing of the process of the 3D model construction, and allow the 3D model to be combined with other 3D techniques to create various practical applications.

## Description

### FIELD OF THE INVENTION

The present invention relates to a three dimensional (3D) model construction technique, and, more particularly, to a cloud 3D model construction system and construction method thereof that enable real-time transmission.

### BACKGROUND OF THE INVENTION

As technology advances, conventional two-dimensional (2D) scan and print technique has been unable to meet users' needs. The latest three-dimensional (3D) scan and print technique involves scanning a 3D object to create a 3D model and then producing a 3D object equivalent/similar to the 3D object being scanned through a 3D-object construction device.

In current 3D model construction techniques, once a 3D object is scanned, data obtained from scanning are sent to a local 3D model construction device for analysis and calculations to construct a 3D model. Thereafter, the 3D object scanned is realized based on the 3D model. More specifically, in current 3D model construction techniques, a 3D object is first scanned and analyzed. Then, a plurality of object data corresponding to the 3D object is generated. These object data are transmitted to a 3D model construction device, which constructs a 3D model and subsequently reconstructs the 3D object. After the construction of the 3D model, if a user finds flaw(s) in the 3D model, scanning can be performed again to construct another 3D model. Therefore, in the prior art, construction of a 3D model begins only after object data are sent to the 3D model construction device, and a 3D object is reconstructed only when no flaw is found in the 3D model. As a result, users not only have to wait for a longer construction time, but also have no real-time knowledge of the current status of the 3D model during construction, which may be inconvenient for the users to use.

Furthermore, the purpose of current 3D scan is to 3D print out an object that is the equivalent of the 3D object scanned. However, if the produced 3D object can be combined with other applications, it may provide more benefits, thereby allowing a wider range of application of the 3D scan and print technique.

From the foregoing, real-time transmission of 3D models is important to current 3D model construction technique. Moreover, if the user is informed of the current construction status of the 3D model during the construction process, it will help the user to determine if the 3D model conforms to the physical object. Therefore, the foregoing requirements for the construction of a 3D model are yet to be solved.

### SUMMARY OF THE INVENTION

In light of the foregoing drawbacks, an objective of the present invention is to provide a cloud 3D model construction technique that allows real-time transmission and feedback between a user and a cloud 3D model platform, providing a real-time and multipurpose 3D model construction system.

In accordance with the above and other objectives, the present invention provides a cloud three dimensional (3D) model construction system, which may include a user apparatus that transmits in real time 3D object data of a physical object and a cloud 3D model platform connected to the user apparatus via a network. The cloud 3D model platform may include a receiving unit, a processing unit and a feedback unit. The receiving unit is used for receiving the 3D object data transmitted by the user apparatus. The processing unit is used for constructing a 3D model in construction based on the 3D object data, and updating in real time the 3D model in construction to continuously construct the 3D model in construction, in order to create a 3D model corresponding to the physical object. The feedback unit is used for transmitting in real time a plane image of the 3D model in construction to the user apparatus to allow a user to view the plane image of the 3D model in construction in real time.

In an embodiment, the user apparatus obtains the 3D object data using a built-in image capturer or an externally connected portable 3D scanner.

In another embodiment, the cloud 3D model construction system may further include a social network platform connected to the cloud 3D model platform, wherein the 3D model of the cloud 3D model platform is combined with an image to produce a 3D image-adhered model and a plane image of the 3D image-adhered model, which is transmitted to the social network platform.

In yet another embodiment, the user apparatus is connected to the cloud 3D model platform to view the plane image of the 3D image-adhered model, and controls the zooming factor or viewing angle of the 3D image-adhered model through an interactive interface.

Moreover, the present invention further provides a cloud three dimensional (3D) model construction method that can be used in a cloud 3D model platform for 3D model construction. The method may include: receiving 3D object data of a physical object from a user apparatus in real time; constructing a 3D model in construction based on the 3D object data and transmitting in real time a plane image of the 3D model in construction to the user apparatus; and updating in real time the 3D model in construction to continuously construct the 3D model in construction, in order to create a 3D model corresponding to the physical object.

In an embodiment, the user apparatus described in the cloud 3D model construction method obtains the 3D object data using a built-in image capturer or an externally connected portable 3D scanner.

In another embodiment, the 3D model is combined with an image to produce a 3D image-adhered model and a plane image of the 3D image-adhered model, which is transmitted to a social network platform.

Compared to the prior art, the cloud 3D model construction system and method proposed according to the present invention allow the user apparatus to transmit in real time the scanned information to the cloud 3D model platform for 3D model construction, and the cloud 3D model platform returns the construction status of the 3D model in real time to the user apparatus, so the user is able to fully grasp the current situation of the construction. In this way, the user can actively observe rather than passively wait for the construction of the 3D model, and adjust the settings in real time if needed. This greatly increases real timeliness and the user's sense of involvement. Moreover, the cloud 3D model construction system can interact with the social network platform. For example, facial images stored or retrieved in real time in the social network platform can be adhered onto the 3D models constructed in the cloud 3D model construction system to obtain facial-image-adhered 3D models, thus creating great benefits in terms of personal viewing and usage and commercial activities.

### BRIEF DESCRIPTION OF THE DRAWINGS

The present invention can be more fully understood by reading the following detailed description of the preferred embodiments, with reference made to the accompanying drawings, wherein:
FIG. 1 is a schematic diagram depicting a cloud three-dimensional (3D) model construction system in accordance with the present invention;
FIG. 2 is a schematic diagram of another embodiment of the cloud 3D model construction system in accordance with the present invention;
FIG. 3 is a schematic diagram depicting a specific embodiment of a user apparatus in the cloud 3D model construction system in accordance with the present invention;
FIG. 4 is a flowchart illustrating a cloud 3D model construction method in accordance with the present invention;
FIG. 5 is a flowchart illustrating constructing a 3D model in the cloud 3D model construction method in accordance with the present invention;
FIG. 6 is a flowchart illustrating interaction with the social network platform in the cloud 3D model construction method; and
FIG. 7 is a schematic diagram illustrating the combination of the cloud 3D model construction system in accordance with the present invention with 3D adhering images.

### DETAILED DESCRIPTION OF THE EMBODIMENTS

The present invention is described by the following specific embodiments. Those with ordinary skills in the arts can readily understand other advantages and functions of the present invention after reading the disclosure of this specification.

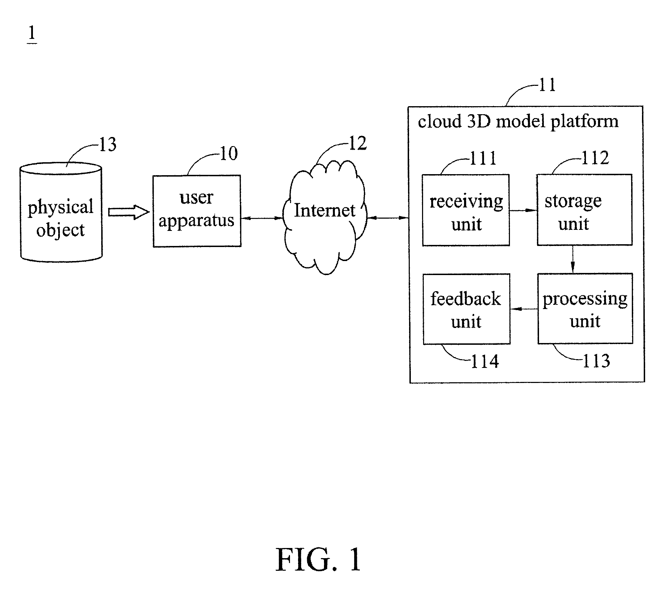

Referring to FIG. 1, a schematic diagram depicting a cloud three-dimensional (3D) model construction system 1 in accordance with the present invention is shown. As shown, in the cloud 3D model construction system 1 of the present invention, a user apparatus 10 and a cloud 3D model platform 11 are networked through the Internet 12. The user apparatus 10 retrieves 3D information of a physical object 13 and sends the 3D information to the cloud 3D model platform 11, which then analyses and constructs a 3D model corresponding to the physical object 13.

The user apparatus 10 is used to transmit 3D object data of the physical object 13 in real time. More specifically, the user apparatus 10 may obtain 3D object data through a built-in image capturer (e.g., a user apparatus 10 with camera functionality) or an externally connected portable 3D scanner. The 3D object data represent the geometric structure or appearance (e.g., color, shape, surface plot, etc.) of the real object or environment detected and analyzed by a 3D scanner, for example. The retrieved data can be used for carrying out 3D construction/reconstruction in order to create a 3D digital model of the real object in a virtual environment.

From the above, the 3D object data represent the physical appearance of the physical object 13. The 3D object data can be obtained in several ways. For example, a 3D picture can be drawn by a 3D illustrator. Alternatively, some bits or object blocks of the physical object 13 are obtained by 3D scan. As another example, object codes corresponding to the physical appearances of physical objects can be assigned in advance, and, after a relevant image or data is obtained and determined, a corresponding 3D model is then found based on the object code. In a specific example, an object code of 0105 is assigned to the physical appearance of a pencil, and once an image of the pencil is obtained and the object code of 0105 is determined, a corresponding 3D model (a pencil) is then found from a database based on the object code.

The cloud 3D model platform 11 can be connected to the user apparatus 10 through the Internet 12. The cloud 3D model platform 11 includes a receiving unit 111, a storage unit 112, a processing unit 113 and a feedback unit 114.

The receiving unit 111 is used to receive the 3D object data transmitted by the user apparatus 10. The 3D object data are stored in the storage unit 112 for subsequent construction of a 3D model.

The processing unit 113 is used to create a "3D model in construction" based on the 3D object data produced by the user apparatus 10 and the physical object 13. In addition, there may be more than one user uploading 3D object data to the cloud 3D model platform 11. As such, the processing unit 113 sorts and stores the 3D object data of the physical object 13 uploaded by the plurality of user apparatuses 10 for creating a 3D model.

The processing unit 113 may start constructing once a certain number of 3D object data have been obtained, without having to wait for all of the 3D object data to be uploaded. Thus, the processing unit 113 is capable of creating a "3D model in construction" from some of the 3D object data. The "3D model in construction" is updated in real time with any newly transmitted 3D object data. When all of the 3D object data are uploaded, a 3D model corresponding to the physical object 13 can be created.

The feedback unit 114 is used to transmit in real time plane images of the "3D model in construction" to the user apparatus 10 so that the user(s) can see the plane images of the "3D model in construction" in real time, that is, the construction status of the 3D model. In other words, the user(s) can see some specific plane images of the "3D model in construction" instead of the "3D model in construction" itself. This will affect the process of the construction of the 3D model to a lesser extent. At the same time, the validity of the specific plane images can be determined in real time.

With the above method, the cloud 3D model platform 11 does not have to wait for all of the 3D object data to be gathered before beginning the construction. This speeds up the 3D model construction process. Furthermore, the feedback unit 114 can transmit the plane images of the "3D model in construction" to the user apparatus 10, so that the users do not have to wait for the completion of the entire 3D model before getting an idea of the construction of the entire 3D model. If a flaw is found in the 3D model construction process, the construction process can be stopped or modified immediately, thereby avoiding wastes of resources and time.

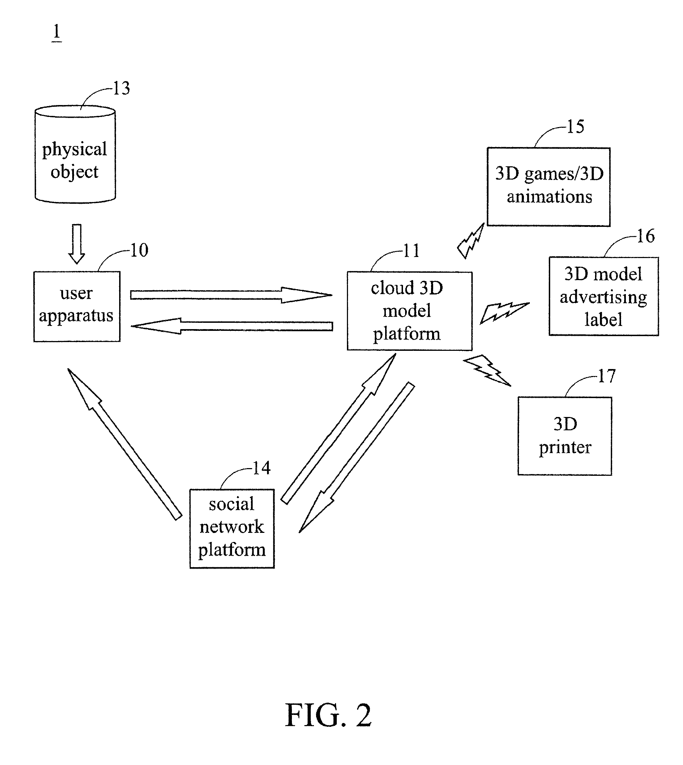

Referring to FIG. 2, a schematic diagram of another embodiment of the cloud 3D model construction system in accordance with the present invention is shown. As shown, this embodiment describes the composition of the cloud 3D model construction system 1 and the application of the 3D model produced by the cloud 3D model platform 11, wherein a social network platform 14 can be connected to the cloud 3D model platform 11 through the Internet, and users can be connected to the social network platform 14 via the user apparatuses 10. Moreover, the social network platform 14 and the cloud 3D model platform 11 can be provided in the same system, but the present invention is not limited as such.

As mentioned before, a user apparatus 10 can obtain the 3D object data of a physical object 13 in several ways, and the 3D object data can be sent to the cloud 3D model platform 11 for the construction of a 3D model. The 3D model matches the physical object 13, and the cloud 3D model platform 11 can transmit in real time plane images of the "3D model in construction" or images of the completed 3D model to the user apparatus 10.

The 3D model constructed by the cloud 3D model platform 11 can be printed by a 3D printer 17 to produce an article the same with or similar to the physical object 13. There is a wide range of applications of 3D printing, such as in human organs, furniture, and so on. Moreover, 3D models can be applied to 3D games/3D animations 15, in which 3D models provide realizations of 3D characters or 3D objects in 3D games or materials for the productions of 3D animations.

In addition, 3D models can be applied to specific manufactures for combining with 3D model advertising label 16. Simply put, an advertising label such as a picture or image can be adhered to a 3D model to produce a 3D model with an advertising label. Accordingly, the advertiser may print out a 3D object using this 3D model, thereby applying 3D models to advertisements. Alternatively, 3D models can be applied to 3D games/3D animations 15 to achieve advertisement.

The social network platform 14 can transmit a picture or a photo in the social network platform 14 (or an external picture or photo) to the cloud 3D model platform 11 to be combined with a 3D model to produce an image-adhered 3D model. A plane image of the image-adhered 3D model is then produced and sent to the social network platform 14. More specifically, 3D models may be just simple 3D models, but if personalization is added, then there can be more applications for the 3D models. For example, a 3D model presents a 3D puppet. If facial photos of the users in the social network platform 14 can be adhered onto the faces of the 3D puppets, then the images of the 3D puppets can be used for interactions in the social network. This specific example regarding image-adhered 3D models is described in more details later.

In addition, the social network platform 14 may combine the plane image of an image-adhered 3D model with an external link that may be linked to the image-adhered 3D model in the cloud 3D model platform 11, an advertising website, or the like. Moreover, the user apparatus 10 can be connected to the social network platform 14, allowing the user to download the plane image of the image-adhered 3D model combined with an external link from the social network platform 14 to the user apparatus 10 in order for the user to be connected to the cloud 3D model platform 11 via the external link. Alternatively, the user apparatus 10 may be connected to the cloud 3D model platform 11 directly to see the plane image of the image-adhered 3D model, wherein the zooming factor or viewing angle of the image-adhered 3D model can be adjusted through an interactive interface of the user apparatus 10, such that the social network platform 14 or the cloud 3D model platform 11 may transmit the plane image of the image-adhered 3D model after the adjustments to the user apparatus 10.

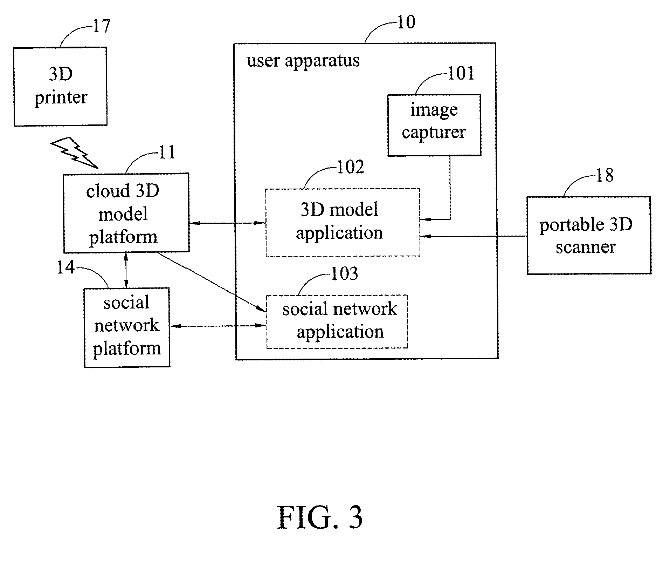

Referring to FIG. 3, a schematic diagram depicting a specific embodiment of the user apparatus 10 in the cloud 3D model construction system in accordance with the present invention is shown. This embodiment further explains the implementation of the user apparatus 10. As shown, the user apparatus 10 can have a built-in image capturer 101, a 3D model application 102, and a social network application 103, in order to connect and interact with the cloud 3D model platform 11 and the social network platform 14. Moreover, the 3D model application 102 and the social network application 103 may be implemented in one application, but the present invention is not limited as such.

When a user wishes to construct a 3D model, he/she may start the 3D model application 102 of the user apparatus 10, and the 3D model application 102 may drive the image capturer 101 or an externally connected portable 3D scanner 18 to obtain images or 3D object data of a physical object. Thereafter, the 3D model application 102 can upload the images or 3D object data to the cloud 3D model platform 11 for the construction of a 3D model and the returning of the images of the 3D model to the user apparatus 10.

After the 3D model is produced, the user may start the social network application 103 to connect to the social network platform 14, and the social network platform 14 may transmit a picture or a photo in the social network platform 14 (or an external picture or photo) to the cloud 3D model platform 11 to be combined with the 3D model to produce an image-adhered 3D model. A plane image of the image-adhered 3D model is then produced and sent to the social network platform 14. Then, the plane image of the image-adhered 3D model is returned to the user apparatus 10. In this way, the user may be connected to the cloud 3D model platform 11 directly to see the plane image of the image-adhered 3D model. When viewing the image-adhered 3D model, the user may rotate, zoom-in or zoom-out the image-adhered 3D model using the user apparatus 10. Moreover, the user may download the plane image of the image-adhered 3D model from the social network platform 14, or the social network platform 14 may combine the plane image of the image-adhered 3D model with an external link and make it available for the user to download. As such, the user only owns the plane image of the 3D model or the plane image of the image-adhered 3D model or the 3D object printed from the 3D printer 17, not the 3D model or the image-adhered 3D model to protect the copyrights of the original creators.

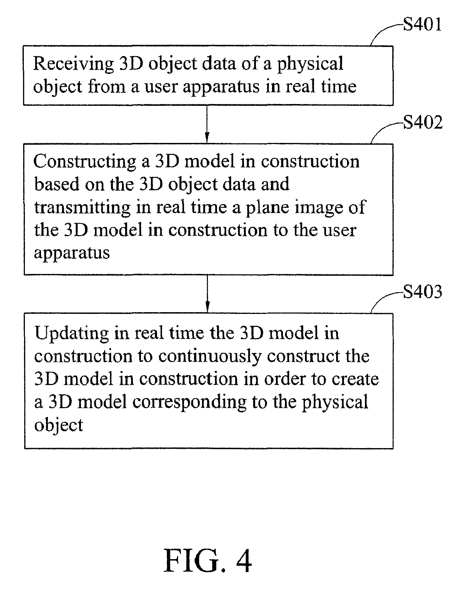

Referring to FIG. 4, a flowchart illustrating a cloud 3D model construction method in accordance with the present invention is shown. As shown in step S401, 3D object data of a physical object provided by a user apparatus are received in real time. More specifically, the user apparatus can obtain the 3D object data or images of the physical object using a built-in image capturer or an externally connected portable 3D scanner. The method proceeds to step S402.

In step S402, a "3D model in construction" is produced based on the 3D object data, and a plane image of the "3D model in construction" is transmitted to the user apparatus in real time. Simply put, the 3D object data received are used for construction of the "3D model in construction". It should be noted that the present invention does not have to wait for all of the 3D object data to be received before the model construction; instead, 3D model construction begins once a certain number of 3D object data is received, thereby forming the "3D model in construction" (not the complete 3D model), and the plane image of the "3D model in construction" can be transmitted to the user apparatus in real time to allow a user of the user apparatus to see the plane image of the "3D model in construction", that is, the construction status of the 3D model. The method proceeds to step S403.

In step S403, the "3D model in construction" is updated in real time to continuously construct the "3D model in construction," in order to produce a 3D model corresponding to the physical object. More specifically, after receiving a new 3D object data, the new 3D object data are combined with the "3D model in construction" to produce a new "3D model in construction". This process is repeated until the entire 3D model is completed. The 3D model may be set in advance to have the same size as the physical object.

Moreover, after the 3D model is created, the 3D model can be combined with a picture or a photo in a social network platform (or an external picture or photo) to produce an image-adhered 3D model. A plane image of the image-adhered 3D model is then produced and sent to the social network platform. The user may download the plane image of the image-adhered 3D model through the user apparatus, or adjust the zooming factor or viewing angle of the image-adhered 3D model through an interactive interface of the user apparatus in order to see the plane image of the image-adhered 3D model.

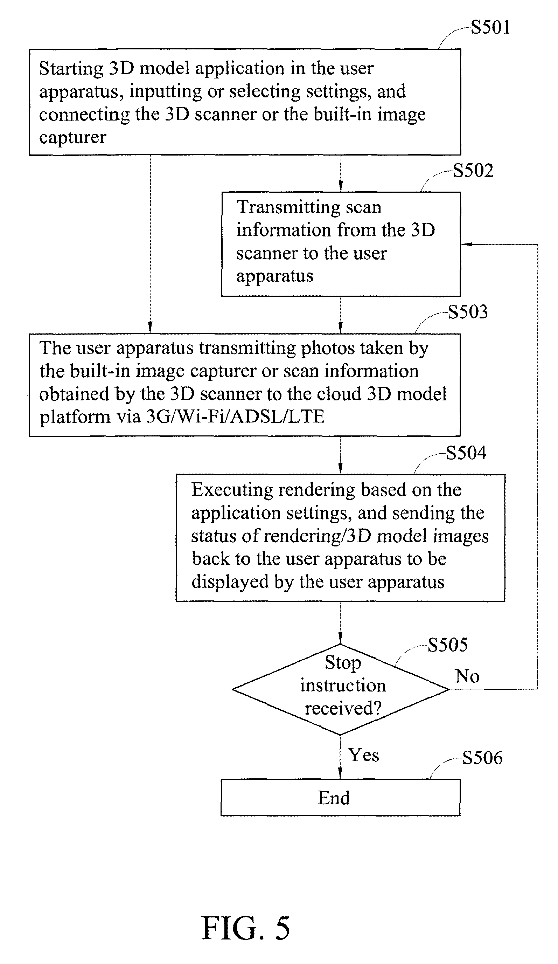

Referring to FIG. 5, a flowchart illustrating 3D model construction in the cloud 3D model construction method in accordance with the present invention is shown. As shown, in step S501, a 3D model application in the user apparatus is started, settings are inputted or selected, and the 3D scanner or the built-in image capturer is connected. In step S501, when a 3D model is to be constructed, the 3D model application in the user apparatus is started, relevant settings are inputted in advance, such as low polygon display/high polygon display/hairstyle/complete object scan/partial object scan, and then the external 3D scanner or the built-in image retrieved is connected for scanning. Then, proceed to step S502 and S503.

In step S502, scan information is transmitted from the 3D scanner to the user apparatus, and 3D scan is performed on the physical object by the 3D scanner to obtain scan information. The scan information may include coordinates/texture/color/object codes corresponding to part of the scan (e.g., hairstyle), and so on, and the scan information is continuously sent back to the user apparatus.

In step S503, the photo taken by the built-in image capturer or scan information obtained by the 3D scanner is received by the user apparatus, and sent to the cloud 3D model platform via wired or wireless methods such as 3G/Wi-Fi/ADSL/LTE, etc. Then, proceed to step S504.

In step S504, rendering is executed based on the application settings, and the status of rendering/3D model images are sent back to the user apparatus to be displayed by the user apparatus. Step S504 includes constructing a 3D model and sending the images back to the user apparatus at the user end. After step S504, step S505 is performed, in which it is determined if a stop instruction given by the user is received. If not, then continue scanning and return to step S502 to obtain new 3D object data (part of data of the retrieved physical object), and then to continue the construction of the 3D model in step S504. Otherwise, if a stop instruction given by the user is received, proceed to step S506 to end the flow of this construction.

Through the foregoing steps, the images or 3D object data of the physical object can be retrieved progressively, and 3D model rendering can be achieved based on the settings to create a 3D model.

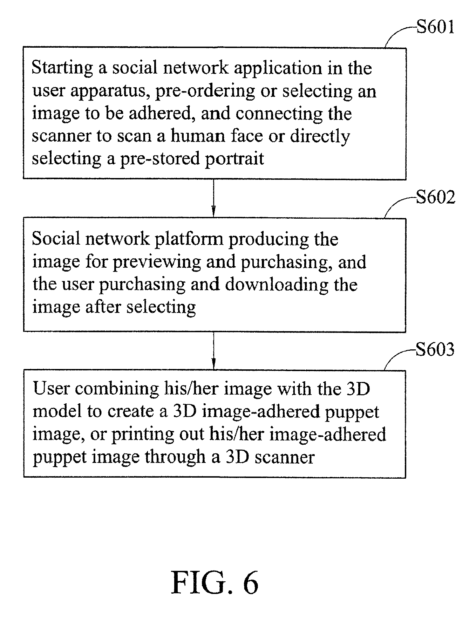

Referring to FIG. 6, a flowchart illustrating interaction with the social network platform in the cloud 3D model construction method is shown. As shown, in step S601, a social network application in the user apparatus is started, an image (or photo) to be adhered is pre-ordered or selected, and the scanner is connected to scan a human face or a pre-stored portrait is selected directly. More specifically, the user starts the social network application in the user apparatus and pre-orders or selects an image already created. If the image is pre-ordered, then the scanner is connected to scan a human face. If the image already exists, the image can be selected for use. Next, proceed to step S602.

In step S602, the social network platform produces the image for previewing and purchasing. The user may purchase and download the image after selecting it. The social network platform produces the adhering image based on the pre-order or selection of the user. After that, the image can be made available to the social network platform for user to preview and purchase. The user can then pay to download the image. Then, proceed to step S603.

In step S603, the user may combine his/her image with the 3D model to create a 3D image-adhered puppet image, or print out his/her image-adhered puppet image through a 3D scanner. In the previous step, the user may obtain a desired image, and then the user may combine the image with a 3D model (a puppet in this example) to create a plane image of a 3D image-adhered puppet, or print out his/her own 3D image-adhered puppet by connecting to an external 3D printer.

Moreover, when the user wishes to transmit a video file in a social network platform, the above technique can be used, in which a plane image of the 3D image-adhered puppet is used to represent the user's emotions or expressions (e.g., happy, angry, sad, etc.) with respect to the video file, thereby increasing interactions between users.

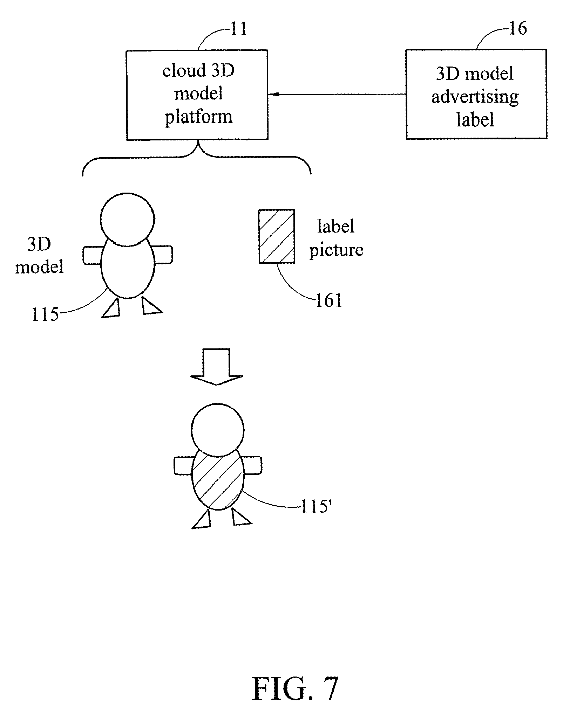

Referring to FIG. 7, a schematic diagram illustrating the combination of the cloud 3D model construction system in accordance with the present invention with 3D adhering images is shown. As shown, the cloud 3D model platform 11 may apply a constructed 3D model (e.g., a puppet) to the manufacturer of a 3D model advertising label 16. At this time, the manufacturer can send the 3D model advertising label 16 to the cloud 3D model platform 11 to combine a 3D model 115 with a label picture 161, thus forming a 3D puppet with a label picture 115'. As a result, by using such a puppet, an advertiser can produce print advertisements or 3D objects, or inserting it into analog or digital advertisements in electronic forms. As such, 3D models adhered with images of advertising labels may create greater benefit. Moreover, the 3D puppet 115' can be used in 3D games/3D animations 15.

In summary, the cloud 3D model construction system and method proposed by the present invention allow the user apparatus to transmit in real time the scanned information to the cloud 3D model platform for 3D model construction, and the cloud 3D model platform returns the construction status of the 3D model in real time to the user apparatus. In this way, the user is able to know the current construction status. Compared to the prior art where the construction and subsequent operations can only be performed after scanned information is uploaded, the present invention not only reduces the overall process time, but also allows users to actively view the contents of construction during the process of construction, this avoids longer construction time and increases user's sense of involvement. Moreover, the cloud 3D model construction system can be combined with the social network platform to create many useful applications. For example, facial images stored or retrieved in real time in the social network platform can be adhered to 3D models to obtain facial-image-adhered 3D models, thus creating many different applications for the 3D model.

The above embodiments are only used to illustrate the principles of the present invention, and should not be construed as to limit the present invention in any way. The above embodiments can be modified by those with ordinary skill in the art without departing from the scope of the present invention as defined in the following appended claims.

## Claims

1. A cloud three dimensional (3D) model construction system, comprising:
a user apparatus that transmits in real time 3D object data of a physical object; and
a cloud 3D model platform connected to the user apparatus via a network and including:
a receiving unit that receives the 3D object data transmitted by the user apparatus;
a processing unit that constructs a 3D model in construction based on the 3D object data, and updates in real time the 3D model in construction to continuously construct the 3D model in construction, in order to create a 3D model corresponding to the physical object; and
a feedback unit that transmits in real time a plane image of the 3D model in construction to the user apparatus to allow a user to view the plane image of the 3D model in construction in real time.

2. The cloud 3D model construction system of claim 1, wherein the 3D object data includes a 3D picture, an object bit, an object block or an object code.

3. The cloud 3D model construction system of claim 1, wherein the user apparatus obtains the 3D object data using a built-in image capturer or an externally connected portable 3D scanner.

4. The cloud 3D model construction system of claim 1, further comprising a social network platform connected to the cloud 3D model platform, wherein the 3D model of the cloud 3D model platform is combined with an image to produce a 3D image-adhered model and a plane image of the 3D image-adhered model, which is transmitted to the social network platform.

5. The cloud 3D model construction system of claim 4, wherein the social network platform combines the plane image of the 3D image-adhered model with an external link, and connects with the user apparatus to allow the user apparatus to download the plane image of the 3D image-adhered model combined with the external link from the social network platform.

6. The cloud 3D model construction system of claim 4, wherein the user apparatus is connected to the cloud 3D model platform to view the plane image of the 3D image-adhered model, and controls a zooming factor or a viewing angle of the 3D image-adhered model through an interactive interface.

7. A cloud three dimensional (3D) model construction method, comprising:
receiving 3D object data of a physical object from a user apparatus in real time;
constructing a 3D model in construction based on the 3D object data and transmitting in real time a plane image of the 3D model in construction to the user apparatus; and
updating in real time the 3D model in construction to continuously construct the 3D model in construction in order to create a 3D model corresponding to the physical object.

8. The cloud 3D model construction method of claim 7, wherein the user apparatus obtains the 3D object data using a built-in image capturer or an externally connected portable 3D scanner.

9. The cloud 3D model construction method of claim 7, wherein the 3D model is combined with an image to produce a 3D image-adhered model and a plane image of the 3D image-adhered model, which is transmitted to a social network platform.

10. The cloud 3D model construction method of claim 9, wherein the user apparatus controls a zooming factor or a viewing angle of the 3D image-adhered model through an interactive interface of the user apparatus.
